Europäisches Patentamt

European Patent Office

Office européen des brevets

(19)

(11) Publication number: **0 015 706**
**B1**

(12) **EUROPEAN PATENT SPECIFICATION**

(45) Date of publication of patent specification: **13.04.83**

(51) Int. Cl.³: **H 03 J 7/24, H 03 D 5/00**

(21) Application number: **80300568.5**

(22) Date of filing: **26.02.80**

(54) **Electronically tunable radio receiver.**

(30) Priority: **26.02.79 JP 22404/79**

a040(43) Date of publication of application:
**17.09.80 Bulletin 80/19**

(45) Publication of the grant of the patent:
**13.04.83 Bulletin 83/15**

(84) Designated Contracting States:
**DE FR GB**

(56) References cited:
**FR - A - 2 313 821**
**US - A - 3 704 422**
**US - A - 3 800 226**

**PATENTS ABSTRACTS OF JAPAN, vol. 2, no.
49, 06-04-1978, page 715E78**

(73) Proprietor: **SHARP KABUSHIKI KAISHA**
**22-22 Nagaike-cho Abeno-ku**
**Osaka 545 (JP)**

(72) Inventor: **Konishi, Hideo 383-2 Tenbayashi
Oazaiida Hachihonmatsu-cho
Higashihiroshima-shi Hiroshima-Ken (JP)**
Inventor: **Matsuoka, Kazunori
2226 Oazaiida Hachihonmatsu-cho
Higashihiroshima-shi Hiroshima-ken (JP)**
Inventor: **Gouya, Takao
332 Oazaiida Hachihonmatsu-cho
Higashihiroshima-shi Hiroshima-Ken (JP)**

(74) Representative: **Wright, Peter David John et al,
R.G.C. Jenkins & Co. 12-15, Fetter Lane
London EC4A 1PL (GB)**

## Electronically tunable radio receiver

Technical Field

This invention relates generally to an electronically tunable type of radio receiver having a scan control for automatically stopping a so-called local oscillation frequency scanning operation at its optimum tuning point.

Background Art

The conventional electronically tunable radio receiver tunable to both FM and AM broadcasting stations includes two separate local oscillators one for FM reception and the other for AM reception, each of which has a different local oscillation frequency. This is due to the fact that the intermediate frequency for FM reception is totally different from that for AM reception. For the type of radio receivers which automatically scan the local oscillation frequency, the scan rate is set at a relatively low level to enable the operator to manually stop the automatic scanning operation on the local oscillation frequency at the optimum tuning point. Radio receivers with the capability of automatically stopping the automatic scanning operation on the local oscillation frequency can accomplish a simple and quick tuning operation but need complicated circuitry for the purpose of automatically stopping the scan operation.

It is well known that such automatic stop circuitry is adapted to take advantage of the intermediate frequency output of an intermediate frequency circuit. To this end it requires two separate automatic stop circuits for FM reception and AM reception due to the fact that the respective intermediate frequencies for FM reception and AM reception are quite different from each other, for example, 10.7 MHz and 450 KHz in Japan.

The automatic stop circuitry is very convenient for the radio receivers with the facility of automatically scanning the local oscillation frequency to achieve optimum reception of any desired broadcasting station, that is, prompt, accurate and simple reception. However, such circuitry has the problems that the circuit arrangement is complex and the two separate stop circuits should be incorporated into the radio receivers independently of each other for FM reception and AM reception. As a matter of fact, the use of the automatic stop circuitry is confined to expensive radio receivers.

U.S. Patents Nos. 3,800,226 and 4,135,158, and Japanese Patent Kokai 53-11509 describe other tuning systems for AM/FM receivers.

In the Japanese document, for example, AM intermediate frequency signals are delivered to an FM tuning circuit and converted into signals of the FM intermediate frequency. Detection circuitry coupled to the output of the FM IF amplifier can then be used to halt the scanning operation during both FM and AM reception modes. However, this arrangement has the disadvantage that in order to achieve the required tuning accuracy fine adjustment of the FM circuitry is required, the bandwidth of the circuitry must be made suitable both for the detection operation and for good-quality reception of FM signals, and a quite complex circuit has to be provided in order to derive from both a level detector and an FM demodulator the signal which is used to half the scanning operation.

Disclosure of the Invention

In accordance with the invention there is provided an electronically tunable AM/FM radio receiver having tuning means operable to vary the frequencies of AM and FM local oscillation signals and responsive to AM and FM intermediate frequency signals for halting the variation of an associated local oscillation signal frequency in response to a received AM or FM radio signal, said tuning means being operable to convert a first of the intermediate frequency signals into a signal of the other intermediate frequency, and including a common detector which is responsive to both the other intermediate frequency signal and the converted first intermediate frequency signal for detecting received FM and AM radio signals, characterised in that the tuning means is operable to convert the FM intermediate frequency signal into the AM intermediate frequency, said common detector being responsive to signals having the AM intermediate frequency.

Because a common circuit is utilised for detecting both FM and AM radio signals and then stopping the scanning operation, a simple and inexpensive circuit structure is achieved. Furthermore, accurate tuning can be achieved by the use of a simple level detector responsive to the signals of the AM intermediate frequency, so that the complex circuits and fine adjustment required in the apparatus of the Japanese document referred to above are no longer needed. This is because, at the AM intermediate frequency, it is fairly easy to provide the level detector with the narrow bandwidth which is necessary to achieve accurate tuning.

Brief Description of the Drawings

FIG. 1 is a block diagram of a radio receiver constructed in accordance with the present invention; and

FIG. 2 is a detailed circuit diagram showing a control circuit contained within the radio receiver of FIG. 1.

Detailed Description of Preferred Embodiment

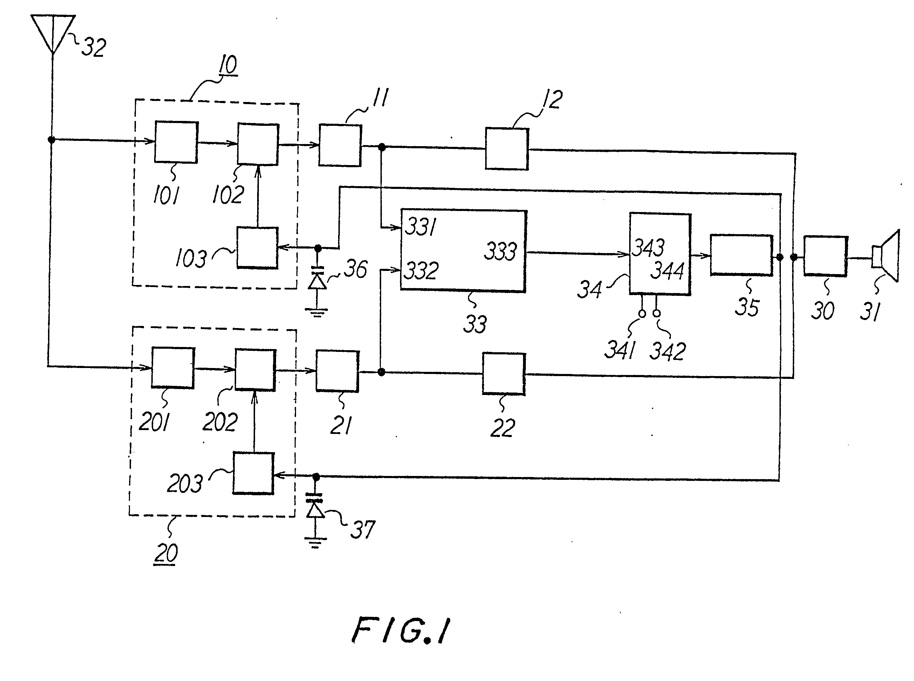

Referring first to FIG. 1, there is illustrated a block diagram of a radio receiver embodying the present invention, which comprises an FM front stage *10* and an AM front stage *20*, the former including an RF amplifier 101, a mixer 102 and a local oscillator 103 and the latter including similarly an RM amplifier 201, a mixer 202 and a local oscillator 203.

An FM intermediate frequency amplifier 11 and an AM intermediate frequency amplifier 21 follow the FM front stage *10* and the AM front stage *20*, respectively. An AF detector 12 and an AM detector 22 are connected between the outputs of the amplifiers 11 and 21 and a series combination of a low frequency amplifier 30 and a loud speaker 31, respectively. Thus, when any FM or AM broadcasting signal is received by an antenna 32, that received signal is converted into the FM intermediate frequency or the AM intermediate frequency via the FM front stage *10* or the AM front stage *20*.

If one of two receiver modes is selected by an AM reception mode/FM reception mode selector (not shown), then either the FM intermediate frequency output or the AM intermediate frequency output will be derived from the intermediate frequency amplifier 11 or 21. After the derived intermediate frequency output is amplified by the low frequency amplifier 30 via the detector 12 or 22, the loud speaker 31 is enabled to deliver audible sounds of any selected FM or AM broadcasting signal.

An automatic tuning detector 33, separate from the above described tuning circuitry, is adapted to develop a tuning instruction for discontinuing the scanning operation. Two input sections 331 and 332 of the detector 33 are connected to the outputs of the FM intermediate amplifier 11 and the AM intermediate amplifier 21 so that either the FM intermediate frequency (10.7 MHz) or the AM intermediate frequency (450 KHz) is supplied to the input section 331 or 332 of the circuit 33 thus permitting the tuning instruction to be delivered from an output section 333.

The tuning instruction is applied to an input section 343 of a control circuit 34 implemented using recently developed microprocessor techniques which is responsive to input data applied to its input data sections 341, 342, etc., for governing the start and end points, direction and speed of the scanning operation. An output section 344 of the control circuit 34 is connected to an input section of a PLL (phase locked loop) circuit 35. As is well known in the art, the PLL circuit 35 includes a crystal standard oscillator, a phase comparator, a low pass filter, a direct current amplifier, a voltage-controlled oscillator and so forth in a loop configuration. The voltage-controlled oscillator could include the above mentioned local oscillators 103 and 203 and variable capacitors 36 and 37. Although two separate local oscillators 103 and 203 are shown, a single voltage-controlled oscillator in the PLL circuit may replace these two local oscillators.

While the control circuit 34 is controlling the local oscillation frequency of the local oscillator 103 or 203, that is, the scanning direction and speed of the oscillation frequency of the voltage-controlled oscillator, one of the two intermediate frequency outputs from the intermediate amplifier 11 or 21 is supplied to the input section 331 or 332 of the control circuit 33 during the selected one of the two receiver modes so that the tuning instruction is derived from the output section 333 of the control circuit 33 and fed to a latch circuit (not shown) contained within the PLL circuit 35. The latch circuit may comprise a well known shift register and operate the PLL circuit if the output of the control circuit 33 is any kind of signal except for the tuning instruction, e.g., a signal representative of the scanning direction and speed. In response to the application of the tuning instruction the shift register stores and circulates the tuning instruction and keeps constant the oscillation frequency of the voltage-controlled oscillator within the PLL circuit and in other words the local oscillators 103 or 203. Since the scanning operation comes to a stop under these circumstances, the intermediate frequency amplifier 11 or 21 continues supplying the intermediate frequency signal to enable the operator to listen to a desired FM or AM broadcasting station.

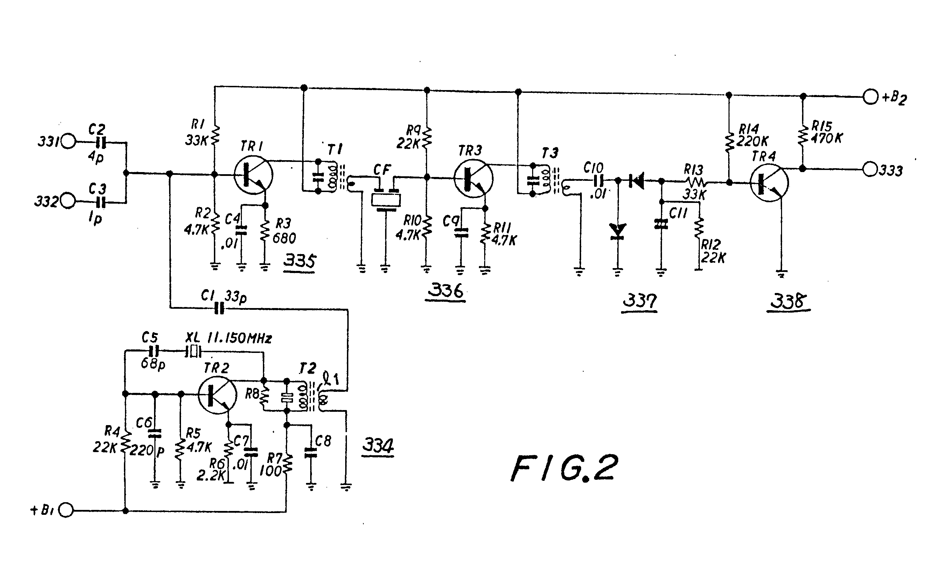

FIG. 2 details the circuit arrangement of the control circuit 33.

It is clear from FIG. 1, that the output section of the control circuit 33 is used in common for FM reception and AM reception for automatically stopping the scanning operation. Referring to FIG. 2, the control circuit 33 particularly includes an oscillator 334, a mixer/amplifier 335, a filter 336 for passing signals of the AM intermediate frequency, a rectifier 337 and a level detector 338. When the FM/AM receiver mode selector switch is turned to the FM receiver mode, the oscillator 334 is supplied with a DC enable voltage from a powder supply line $+B_1$ and its oscillation frequency is fixed at 11.150 MHz to 10.250 MHz with a quartz piezo-electric transducer XL.

The oscillator 334 is connected to an FM intermediate frequency input terminal 331 via a secondary coil $l_1$ of an output transformer $T_2$, a capacitor $C_1$ and another capacitor $C_2$. When the oscillator 334 is caused to oscillate by the enable voltage supplied from the line $+B_1$ during the FM receiver mode, the FM intermediate frequency 10.7 MHz is applied to the input section 331 and then converted into 11.150 − 10.7 (n MHz) = 450 (in KHz) or 10.7 − 10.25 (in MHz) = 450 (in KHz). In other words, the oscillation frequency of the oscillator 334 is mixed with the FM intermediate frequency at the junction of the capacitors $C_1$ and $C_2$. During the FM receiver mode the mixer/amplifier 335 serves as a converter with respect to the FM intermediate frequency and converts the FM intermediate frequency into agreement with the AM intermediate frequency. The next succeeding filter 336 having a band width of $\pm 6$ KHz centering on 450 KHz determines the accuracy of the tuning instruction. The resulting AM intermediate frequency signal is amplified via the filter 336 and rectified via the next succeeding rectifier 337. The band width $\pm 6$ KHz of the filter 336 is enough to achieve the optimum tuning operation since at least 50 KHz is allotted between two adjacent broadcasting stations pursuant to the Radio Law in Europe.

The AM intermediate frequency outputted from the rectifier circuit 337 inverts the operating state of the level detector 338 consisting of a conventional switching circuit such as a Schmitt trigger circuit. In other words, when no FM intermediate frequency signal is applied to the input terminal 331 or when no AM intermediate frequency signal is applied to the other input terminal 332, a transistor TR4 within the level detector 338 is biased with a power supply voltage $+B_2$ and placed in the conductive state with its collector electrode at the ground potential.

When the output section 333 of the control circuit 33 is held at the ground potential, the latch circuit contained within the PLL circuit 35 does not operate and the local oscillator continues executing the scanning operation. Thereafter, if the AM intermediate frequency signal is applied to the rectifier circuit 337, then the transistor TR4 within the level detector 338 changes from the conductive state to the nonconductive one with its collector voltage increasing to a high level. At this moment the output section 333 of the control circuit 33 is maintained at a high level so that the latch circuit in the PLL circuit 35 operates in the above described manner to automatically stop the scanning operation by the local oscillator.

When the receiver is turned to the AM reception mode, no DC operating voltage $+B_1$ is supplied to the oscillator 334 which in turn is in the disabled state. Upon the subsequent application of the AM intermediate frequency output to the other input section 332 of the control circuit 33 this AM intermediate frequency output is amplified by the mixer/amplifier 335. While the circuit 335 may serve as a mixer during the FM receiver mode, it actually serves as an AM intermediate frequency amplifier at this time because the oscillator 334 is not active.

The AM intermediate frequency signal enables the level detector 338 via the amplifier 335 and the same path as for converted FM intermediate frequency signals to deliver the tuning instruction.

As an alternative, the AM intermediate frequency signal may be supplied directly to the filter amplifying stage for the development of the tuning instruction.

It will be appreciated that the present invention is of significant advantage in small sized receivers such as car radio receivers, and combined car radio receiver and cassette tape recorders.

## Claims

1. An electronically tunable AM/FM radio receiver having tuning means (33 to 37) operable to vary the frequencies of AM and FM local oscillation signals and responsive to AM and FM intermediate frequency signals for halting the variation of an associated local oscillation signal frequency in response to a received AM or FM radio signal, said tuning means (33 to 37) being operable to convert a first of the intermediate frequency signals into a signal of the other intermediate frequency, and including a common detector (338) which is responsive to both the other intermediate frequency signal and the converted first intermediate frequency signal for detecting received FM and AM radio signals, characterised in that the tuning means (33 to 37) is operable to convert the FM intermediate frequency signal into the AM intermediate frequency, said common detector (338) being responsive to signals having the AM intermediate frequency.

2. A radio receiver as claimed in claim 1, wherein said tuning means (33 to 37) includes an oscillator (334) responsive to selection of an FM reception mode for providing a signal of predetermined frequency for mixing with the FM intermediate frequency signal to convert it into said signal of the AM intermediate frequency.

3. A radio receiver as claimed in claim 1 or claim 2, having an FM local oscillator (103) and an AM local oscillator (203), the frequencies of both of which can be varied by said tuning means (33 to 37).

4. A radio receiver as claimed in claim 1 or claim 2, having a common local oscillator for providing both an FM local oscillation signal and an AM local oscillation signal, the frequency of the common local oscillator being variable by said tuning means (33 to 37).

5. A radio receiver as claimed in any preceding claim, comprising AM and FM circuits (10, 11, 12, 20, 21, 22) each comprising a front stage (10, 20) for receiving radio signals and generating intermediate frequency signals, an intermediate frequency amplifier (11, 21) and a detector (12, 22), wherein said tuning means (33 to 37) is responsive to signals received from said intermediate frequency amplifiers (11, 21) via signal paths which are independent from the signal paths through said respective AM and FM circuits (10, 11, 12, 20, 21, 22).

## Revendications

1. Récepteur radiophonique MA/MF accordable par voie électronique, comprenant des moyens d'accord (33 à 37) servant à faire varier les fréquences des signaux d'oscillation locale MA et MF et sensibles à des signaux de fréquence intermédiaire MA et MF pour arrêter la variation de la fréquence d'un signal d'oscillation locale associé en réponse à un signal radiophonique MA ou MF, lesdits moyens d'accord (33 à 37) servant à convertir un premier des signaux de fréquence intermédiaire en un signal à l'autre fréquence intermédiaire, et comprenant un détecteur commun (338) qui est sensible à la fois à l'autre signal de fréquence intermédiaire et au premier signal de fréquence intermédiaire converti pour détecter les signaux radiophoniques reçus en MF et MA, caractérisé en que les moyens d'accord (33 à 37) servent à convertir le signal de fréquence intermédiaire MF en fréquence intermédiaire MA, ledit détecteur commun (338) étant sensible à des signaux à la fréquence intermédiaire MA.

2. Récepteur radiophonique selon la revendication 1, caractérisé en ce que les moyens d'accord (33 à 37) comprennent un oscillateur (334) sensible à la sélection d'un mode de réception en MF pour fournir un signal de fréquence prédéterminée destiné à être mélangé au signal de fréquence intermédiaire en MF pour le convertir en ledit signal à la fréquence intermédiaire MA.

3. Récepteur radiophonique selon la revendication 1 ou la revendication 2, comprenant un oscillateur local MF (103) et un oscillateur local MA (203), dont les fréquences des deux peuvent être variées à l'aide des moyens d'accord (33 à 37).

4. Récepteur radiophonique selon la revendication 1 ou la revendication 2, comprenant un oscillateur local commun destiné à fournir un signal d'oscillation locale MF et un signal d'oscillation locale AM, la fréquence de l'oscillateur local commun pouvant être variée par les moyens d'accord (33 à 37).

5. Récepteur radiophonique selon l'une quelconque des revendications précédentes, comprenant des circuits MA et MF (10, 11, 12, 20, 21, 22) comprenant chacun un étage d'entrée (10, 20) destiné à recevoir des signaux radio et à générer des signaux de fréquence intermédiaire, un amplificateur de fréquence intermédiaire (11, 21) et un détecteur (12, 22), dans lequel lesdits moyens d'accord (33 à 37) sont sensibles à dex signaux reçus en provenance des amplificateurs de fréquence intermédiaire (11, 21) sur des trajets de signaux qui sont sensibles à des signaux reçus en proversant les circuits respectifs MA et MF (10, 11, 12, 20, 21, 22).

**Patentansprüche**

1. AM/FM-Rundfunkempfänger mit elektronischer Senderabstimmung, mit

— einer FM- und AM-Zwischenfrequenzsignale des Empfängers aufnehmenden Abstimmeinrichtung (33 bis 37) zur Veränderung der Frequenzen der lokal erzeugten FM- und AM-Oszillatorsignale, zum Stillsetzen einer Oszillatorfrequenz-Veränderung in Abhängigkeit vom empfangenen FM- oder AM-Rundfunksignal und zur Umsetzung des einen, ersten Zwischenfrequenzsignals in ein Signal der anderen Zwischenfrequenz, und

— einer gemeinsamen Detektorschaltung (338) zum Ermitteln empfangener FM- und AM-Rundfunksignale in Abhängigkeit sowohl des anderen als auch des ersten der Zwischenfrequenzsignale, dadurch gekennzeichnet, daß die Abstimmschaltung (33 bis 37) zur Umsetzung des FM-Zwischenfrequenzsignals auf die AM-Zwischenfrequenz eingerichtet und die gemeinsame Detektorschaltung (338) zur Verarbeitung von die AM-Zwischenfrequenz aufweisenden Signalen ausgelegt sind.

2. Rundfunkempfänger nach Anspruch 1, dadurch gekennzeichnet, daß die Abstimmschaltung (33 bis 37) einen Oszillator (334) enthält, der, wenn der Empfänger auf FM-Empfang geschaltet ist, ein Signal festgelegter Frequenz zur Mischung des FM-Zwischenfrequenzsignals und zur Umsetzung des FM—ZF-Signals in das die AM-Zwischenfrequenz aufweisende Signal bereitstellt.

3. Rundfunkempfänger nach Anspruch 1 oder 2, mit je einem Empfängeroszillator für den FM-Bereich und den AM-Bereich, dadurch gekennzeichnet, daß die Frequenzwerte beider Empfängeroszillatoren (103, 203) von der Abstimmschaltung (33 bis 37) aus veränderbar sind.

4. Rundfunkempfänger nach Anspruch 1 oder 2, mit gemeinsamen Empfängeroszillator für den FM- und den AM-Bereich, dadurch gekennzeichnet, daß die Frequenz des gemeinsamen Empfängsoszillators von der Abstimmschaltung (33 bis 37) aus veränderbar ist.

5. Rundfunkempfänger nach einem der vorstehenden Ansprüche, mit jeweils eine Eingangsstufe (10, 20) zur Aufnahme von Rundfunksignalen des AM- bzw. des FM-Bereichs und zur Erzeugung von Zwischenfrequenzsignalen, mit je einem Zwischenfrequenzverstärker (11, 21) und mit je einer Detektorstufe (12, 22), dadurch gekennzeichnet, daß die Abstimmschaltung (33 bis 37) durch Signale aus beiden Zwischenfrequenzverstärkern (11, 21) beaufschlagt ist, die über Signalwege zugeführt werden, welche von den durch die beiden FM- und AM-Empfangsschaltungen (10, 11, 12; 20, 21, 22) führenden Signalpfaden unabhängig sind.

FIG.1

FIG.2